# EUROPEAN PATENT APPLICATION

(11) **EP 4 531 098 A1**
(43) Date of publication of application: **02.04.2025**
(21) Application number: 24203071.6
(22) Date of filing: 27.09.2024
(51) Int. Cl.: H01L 23/427, H01L 23/473, F28F 3/02, F28F 13/08, H01L 23/367, H05K 7/20

(54) **LIQUID COOLING DEVICE**

(30) Priority: 27.09.2023 TW 112137066
(71) Applicant: Cooler Master Co., Ltd., Taipei City 114065 (TW)
(72) Inventor: SAHOO, Venkata Raman, 114065 Taipei City (TW)
(74) Representative: Grünecker Patent- und Rechtsanwälte PartG mbB

(57) **Abstract**

A liquid cooling device includes a thermal conduction base, a thermal conduction cover and at least one piercing component. The thermal conduction base has a liquid storage space and a thermal contact surface. The thermal contact surface faces away from the liquid storage space. The thermal conduction cover is disposed on the thermal conduction base, and covers the liquid storage space. The at least one piercing component is located in the liquid storage space, and has a plurality of protrusions. The plurality of protrusions face the thermal contact surface.

## Description

### TECHNICAL FIELD

The present disclosure relates to a liquid cooling device, in particular to a liquid cooling device having piercing components.

### BACKGROUND OF THE DISCLOSURE

With the rapid development of science and technology, the computing performance of various kinds of electronic components has improved considerably, with large amounts of heat being produced at the same time. To ensure that an electronic component is not damaged due to high heat, a cooling device must be fitted to the electronic component to dissipate excess heat.

Electronic components are often cooled by a two-phase liquid cooling system, to maintain their performance and service life. The meaning of "two-phase liquid cooling system" is that a cooling fluid in a liquid state in the liquid cooling system absorbs heat generated by electronic components and thus experiences a phase change, thereby evaporating to become a cooling fluid in a gaseous state, so that bubbles are produced, and the heat generated by the electronic components is carried away. However, in an existing two-phase liquid cooling system, the bubbles produced by the cooling fluid in the liquid state when it is heated will obstruct the flow of the cooling fluid in the liquid state, and this will have an impact on heat transfer, reducing the efficiency of cooling. Thus, the issue of how to further improve the cooling efficiency of two-phase liquid cooling devices is a problem that research and development personnel should solve.

### SUMMARY OF THE DISCLOSURE

Exemplary embodiments of the present disclosure provide a liquid cooling device which may, but is not required to, further improve the cooling efficiency of a two-phase liquid cooling device.

Exemplary embodiment of the present disclosure provide a liquid cooling device comprising a thermal conduction base, a thermal conduction cover and at least one piercing component. The thermal conduction base has a liquid storage space and a thermal contact surface. The thermal contact surface faces away from the liquid storage space. The thermal conduction cover is arranged on the thermal conduction base, and covers the liquid storage space. The at least one piercing component is located in the liquid storage space, and has multiple protruding structures. These protruding structures face toward the thermal contact surface.

According an exemplary implementations of a liquid cooling device according to exemplary embodiments of the disclosure, such as an embodiment described above, after absorbing heat transferred by a heat source, a cooling fluid can boil and produce bubbles, and as the period of operation of the liquid cooling device increases, the bubbles can gradually accumulate and thereby increase in volume, and then can obstruct the flow of cooling fluid and increase a pressure drop, thus reducing the cooling efficiency. For this reason, the piercing components are provided in the liquid cooling device, so that when the large-volume bubbes float upward, the piercing components can pierce the large-volume bubbles to disperse them into multiple small-volume bubbles, so that the small-volume bubbles can be discharged from the liquid storage space more easily. In this way, obstruction to the flow of cooling fluid can, but is not required to, be reduced without affecting heat transfer, so the cooling efficiency can be increased.

The description of the content of the present disclosure above and the description of exemplary embodiments below are intended to demonstrate and explain the principle of the present disclosure, and can facilitate further understanding of the appended claims of the present disclosure.

### BRIEF DESCRIPTION OF THE DRAWINGS

A more complete appreciation of the present disclosure and many of the attendant advantages thereof will be readily obtained as the same becomes better understood by reference to the following detailed description when considered in connection with the accompanying drawings, wherein:
Fig. 1 is a 3D schematic drawing of a liquid cooling device according to a first exemplary embodiment of the present disclosure.
Fig. 2 is an exploded schematic drawing of the liquid cooling device in Fig. 1.
Fig. 3 is a partially enlarged exploded schematic drawing of the liquid cooling device in Fig. 1.
Fig. 4 is a sectional schematic drawing taken along section line 4-4 in the liquid cooling device in Fig. 1.
Fig. 5 is a sectional schematic drawing taken along section line 5-5 in the liquid cooling device in Fig. 1.
Fig. 6 is a partially enlarged sectional schematic drawing taken along section line 5-5 in the liquid cooling device in Fig. 1.
Fig. 7 is a sectional schematic drawing of an example of bubbles being produced in the liquid storage space of the liquid cooling device in Fig. 1.
Fig. 8 is a sectional schematic drawing of an example of bubbles being pierced by the piercing components in the liquid storage space of the liquid cooling device in Fig. 1.
Fig. 9 is a 3D schematic drawing of a liquid cooling device according to a second exemplary embodiment of the present disclosure.
Fig. 10 is an exploded schematic drawing of the liquid cooling device in Fig. 9.
Fig. 11 is a partially enlarged exploded schematic drawing of the liquid cooling device in Fig. 9.
Fig. 12 is a sectional schematic drawing taken along section line 12-12 in the liquid cooling device in Fig. 9.
Fig. 13 is a partially enlarged sectional schematic drawing of the liquid cooling device in Fig. 9.
Fig. 14 is a partially enlarged exploded schematic drawing of a liquid cooling device according to a third exemplary embodiment of the present disclosure.
Fig. 15 is a sectional schematic drawing of the liquid cooling device in Fig. 14.
Fig. 16 is a partially enlarged sectional schematic drawing of the liquid cooling device in Fig. 14.

### DETAILED DESCRIPTION OF EXEMPLARY EMBODIMENTS

The matters exemplified in this description are provided to assist in a comprehensive understanding of exemplary embodiments of the disclosure. Accordingly, those of ordinary skill in the art will recognize that various changes and modifications of the embodiments described herein can be made without departing from the scope and spirit of the described disclosure. Also, descriptions of well-known functions and constructions are omitted for clarity and conciseness.

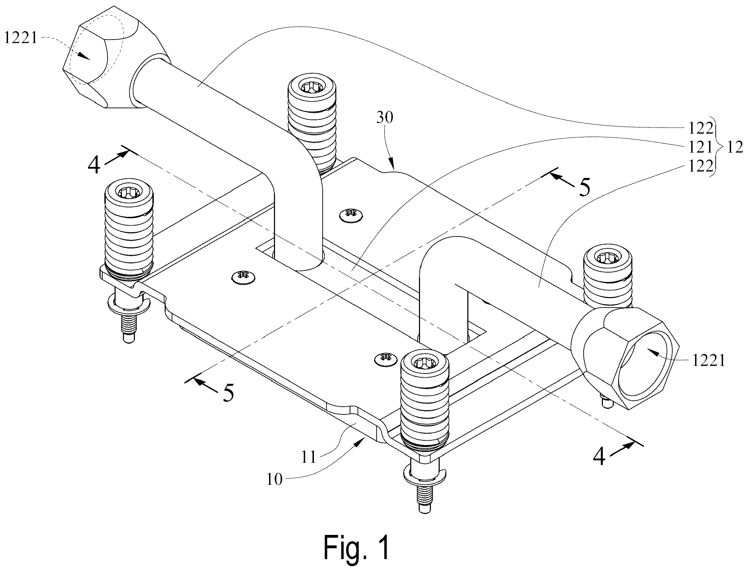

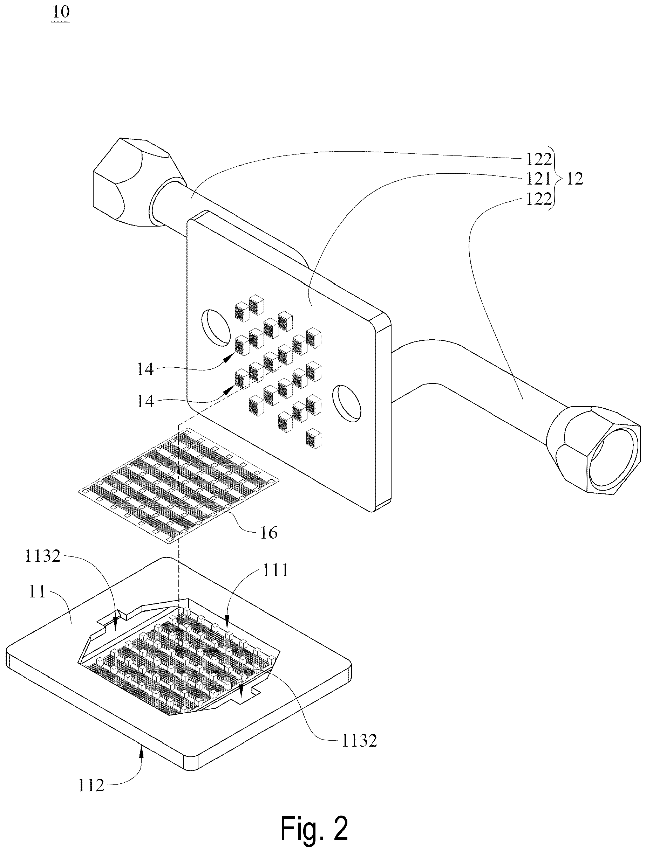

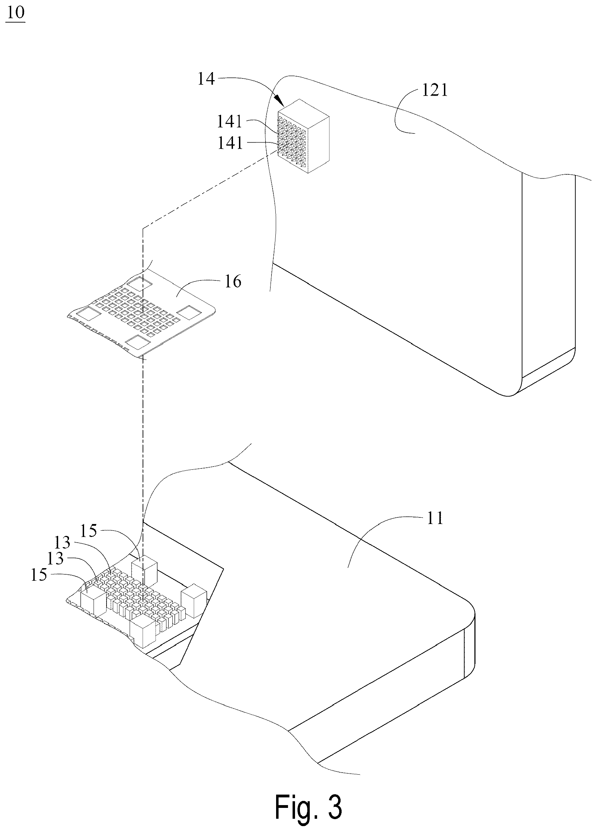

Referring to Figs. 1 - 3, Fig. 1 is a 3D schematic drawing of a liquid cooling device according to an exemplary embodiment of the present disclosure, Fig. 2 is an exploded schematic drawing of the liquid cooling device in Fig. 1, and Fig. 3 is a partially enlarged exploded schematic drawing of the liquid cooling device in Fig. 1.

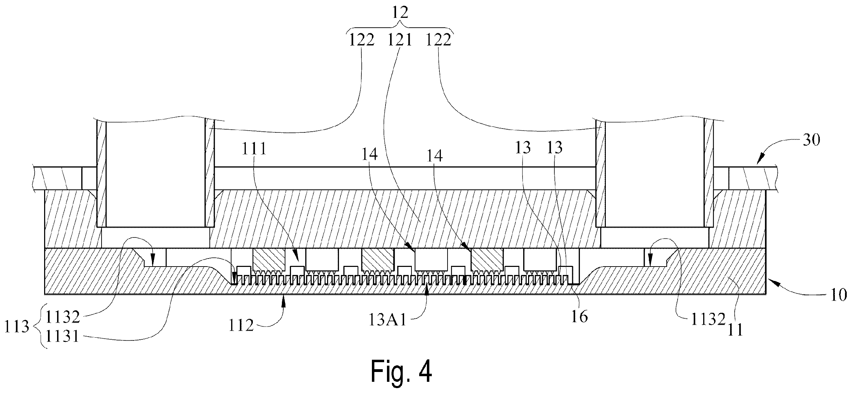

According to an exemplary implementation, a liquid cooling device 10 in the exemplary embodiment is for example a water cooling plate, and may for example be fixed to an electronic device (not shown) by means of an assembly component 30. The liquid cooling device 10 can comprise a thermal conduction base 11, a thermal conduction cover 12, multiple cooling structures 13 and multiple piercing components 14. Fig. 4 is a sectional schematic drawing taken along section line 4-4 in the liquid cooling device in Fig. 1. In an exemplary implementation, the thermal conduction base 11 can have a liquid storage space 111, a thermal contact surface 112 and a bottom surface 113. The liquid storage space 111 can be used for storing a cooling fluid (not shown). The cooling fluid is for example a refrigerant or water.

According to exemplary implementations, the thermal contact surface 112 faces away from the liquid storage space 111. The thermal contact surface 112 can be configured to be in thermal contact with a heat source (not shown) or connected thereto via another thermal conduction medium, and transfers heat generated by the heat source to the cooling fluid located in the liquid storage space 111. In an exemplary implementation, the bottom surface 113 is located in the liquid storage space 111, and faces away from the thermal contact surface 112.

According to an exemplary implementation, the thermal conduction cover 12 can be arranged on the thermal conduction base 11 by brazing for example, and cover the liquid storage space 111. In an exemplary implementation, the thermal conduction cover 12 comprises a plate body 121 and two outlet/inlet pipes 122. The two outlet/inlet pipes 122 can be connected to the plate body 121 by brazing for example. The two outlet/inlet pipes 122 can have two exit/entry ports 1221. The two exit/entry ports 1221 can be in communication with the liquid storage space 111, and configured to allow cooling fluid to flow into and out of the liquid storage space 111.

According to an exemplary implementation, the cooling structures 13 are for example thermal conduction protruding posts, are formed by milling for example, and take the form of square posts for example. The cooling structures 13 protrude from the bottom surface 113. In an exemplary implementation, the bottom surface 113 comprises a first surface part 1131 and two second surface parts 1132. The two second surface parts 1132 are respectively connected to two opposite sides of the first surface part 1131, and the first surface part 1131 is closer to the thermal contact surface 112 than the two second surface parts 1132 are. The cooling structures 13 protrude from the first surface part 1131. The two second surface parts 1132 respectively correspond to the two exit/entry ports 1221.

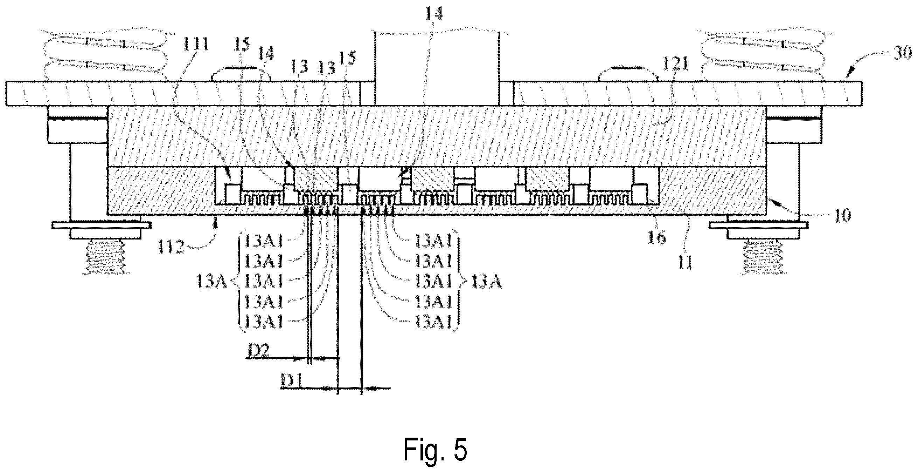

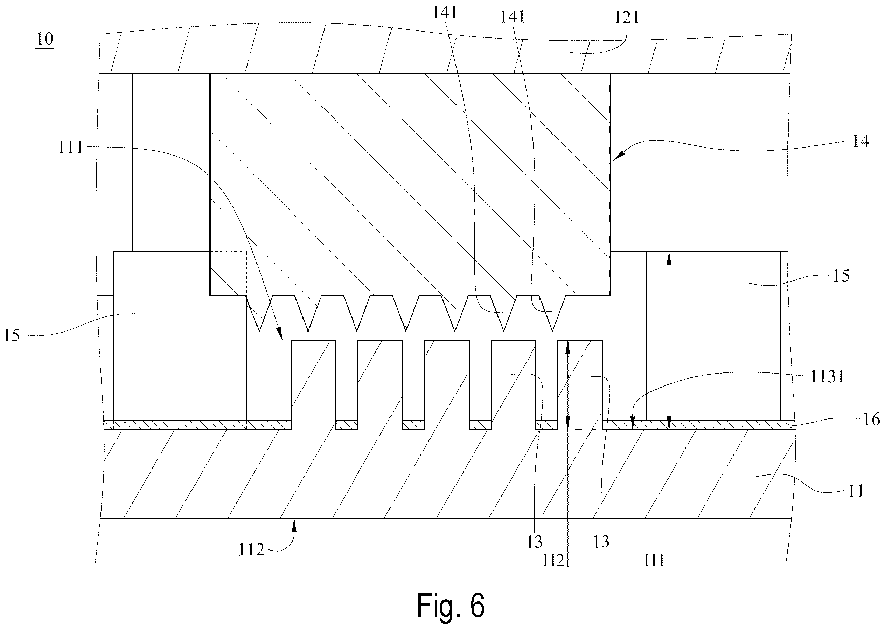

Refer to Figs. 5 and 6, Fig. 5 is a sectional schematic drawing taken along section line 5-5 in the liquid cooling device in Fig. 1, and Fig. 6 is a partially enlarged sectional schematic drawing taken along section line 5-5 in the liquid cooling device in Fig. 1.

According to an exemplary implementation, a distance between the center of each cooling structure 13 and the center of another cooling structure 13 adjacent thereto can be 0.75 mm for example, and the cooling structures 13 can be divided into multiple groups. In an exemplary implementation, each group of cooling structures 13A can comprise multiple rows of cooling structures 13A1. A spacing D1 between any adjacent two of the groups of cooling structures 13A can be greater than a spacing D2 between any adjacent two of the rows of cooling structures 13A1 in the same group. That is, in exemplary implementations, the rows of cooling structures 13A1 in the same group can be arranged more closely together than the groups of cooling structures 13A.

According to an exemplary implementation, the piercing components 14 are copper blocks for example, and can be integrally formed with the thermal conduction cover 12 for example. The piercing components 14 are configured to pierce bubbles (not shown) produced by the cooling fluid when it is heated. In an exemplary implementation, the piercing components 14 can be located in the liquid storage space 111, and can be sintered to the thermal conduction cover 12 for example. In a further exemplary implementation, the piercing components 14 can be divided into multiple rows, each row of the piercing components 14 respectively corresponding to each group of the cooling structures 13.

According to an exemplary implementation, a spacing D3 between any adjacent two of each row of the piercing components 14 can be greater than a spacing D4 between any adjacent two of each group of the cooling structures 13. That is, in exemplary implementations, the piercing components 14 can be arranged further apart than the cooling structures 13. In a further exemplary implementation, the spacing D2 between any adjacent two of the rows of cooling structures 13A1 is for example the same as the spacing D4 between any adjacent two of each group of the cooling structures 13.

According to an exemplary implementation, the piercing components 14 can have multiple protruding structures 141. In an exemplary implementation, the protruding structures 141 take the form of square pyramids for example, and face toward the thermal contact surface 112. That is, in an exemplary implementation, a surface in the protruding structures 141 that is remote from the thermal conduction cover 12 faces toward the thermal contact surface 112. A portion of the protruding structures 141 can overlap a portion of the cooling structures 13.

According to an exemplary embodiment, after absorbing heat transferred by the heat source, the cooling fluid can boil and produce bubbles, which can obstruct the flow of cooling fluid and increase a pressure drop, thus reducing the cooling efficiency. Thus, an exemplary advantage of providing the piercing components 14 in the liquid cooling device 10 is that, once the bubbles have been produced, the piercing components 14 can pierce the bubbles to disperse the vapor present in the bubbles, so that the vapor can be discharged from the liquid storage space 111 more easily. In exemplary implementations of exemplary embodiments, obstruction to the flow of cooling fluid can be reduced without affecting heat transfer, so the cooling efficiency can, but is not required to, be increased.

According to a further exemplary embodiment, the liquid cooling device 10 may further comprise multiple upright posts 15. The upright posts 15 can take the form of square posts for example. In an exemplary implementation, the upright posts 15 can protrude from the bottom surface 113, and can be respectively located in a gap between any adjacent two of the groups of cooling structures 13A. In a further exemplary implementation, a height H1 of each upright post 15 is for example higher than a height H2 of each cooling structure 13. In yet further exemplary implementation, the upright posts 15 can be configured to open up the liquid storage space 111 further, to give the cooling fluid and vapor enough space to flow.

In an exemplary implementation of exemplary embodiment, the liquid cooling device 10 may further comprise a capillary structure 16. The capillary structure 16 can be for example a copper mesh, and can be sintered to the bottom surface 113 of the thermal conduction base 11. Holes of the capillary structure 16 can easily become nucleation points for boiling; therefore, only a relatively low overheating temperature may be needed to cause the cooling fluid to boil, so thermal resistance can, but not required to, be further reduced.

In further exemplary implementation of exemplary embodiment, the cooling structures 13 can be formed by milling, but this is not a limitation. In other exemplary implementations of embodiments, the cooling structures could also be formed by laser cutting for example.

In still further exemplary implementation of exemplary embodiment, there can be multiple piercing components 14, and the piercing components 14 can be arranged on the thermal conduction cover 12 in a dispersed manner, but this is not a limitation. In other exemplary embodiments, there could also be just a single piercing component, and the cooling structures can be located within the range of a projection of the piercing components onto the first surface part of the bottom surface.

In yet further exemplary implementation of exemplary embodiment, the protruding structures 141 of the piercing components 14 can take the form of square pyramids, but this is not a limitation. In other exemplary embodiments, the protruding structures of the piercing components could also take the form of, for example, a polygonal pyramid, a truncated polygonal pyramid, a circular cone or a truncated circular cone.

According to exemplary implementations of exemplary embodiments, the spacing D2 between any adjacent two of the rows of cooling structures 13A1 can be the same as the spacing D4 between any adjacent two of each group of the cooling structures 13, but this is not a limitation. In other exemplary implementations of exemplary embodiments, the spacing between any adjacent two of the rows of cooling structures could also be different from the spacing between any adjacent two of each group of the cooling structures.

In exemplary implementations of the example embodiment, the capillary structure 16 can be a copper mesh, but this is not a limitation. In other exemplary embodiments, the capillary structure could also be, for example, a sintered body of powder or fibers.

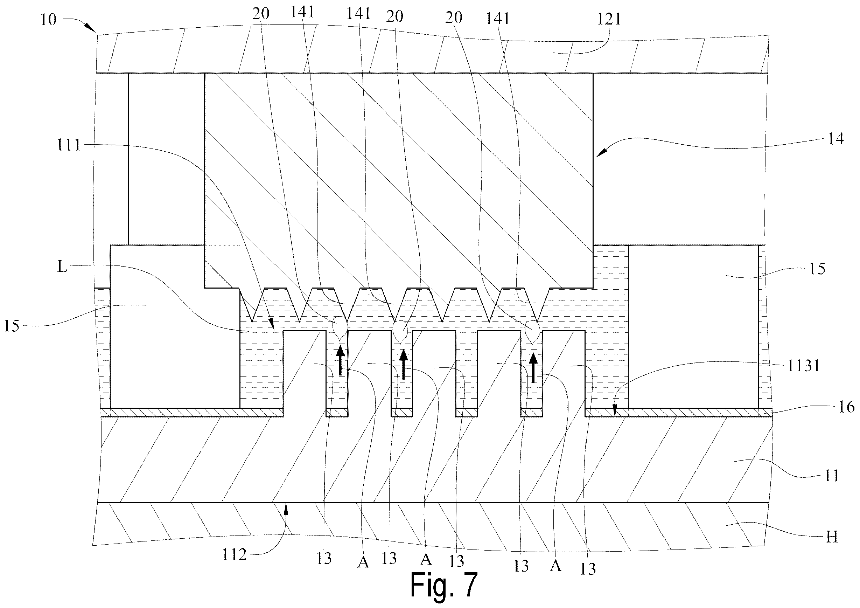

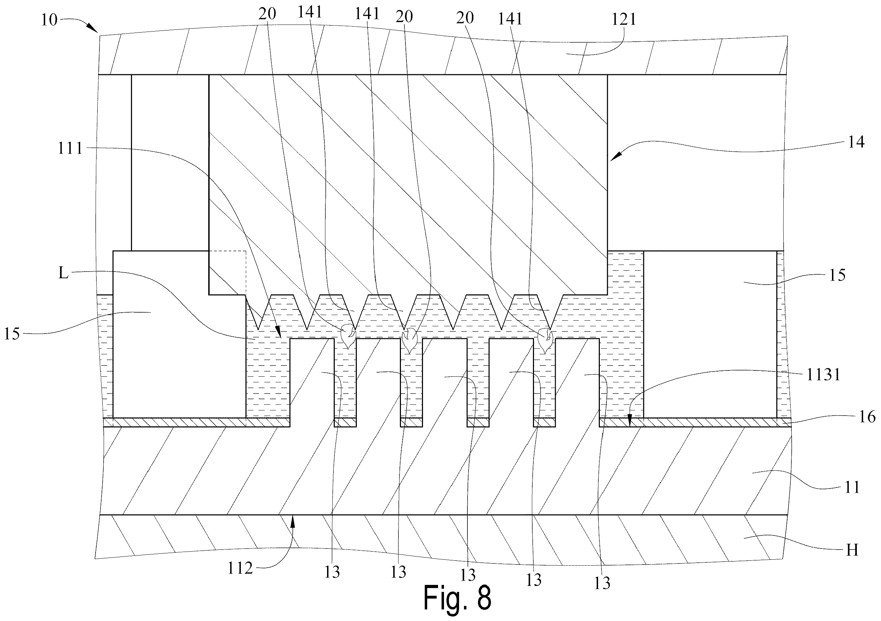

Referring to Figs. 7 and 8, Fig. 7 is a sectional schematic drawing of an example of bubbles being produced in the liquid storage space of the liquid cooling device in Fig. 1, and

Fig. 8 is a sectional schematic drawing of an example of bubbles being pierced by the piercing components in the liquid storage space 111 of the liquid cooling device in the example of Fig. 1.

As shown in Fig. 7, according to exemplary embodiments of the disclosure, the liquid cooling device 10 can be thermally coupled to the heat source H, and heat generated by the heat source H can be transferred to the cooling fluid L through the thermal contact surface 112. When heated, the cooling fluid L can produce multiple bubbles 20. As the period of operation of the liquid cooling device 10 increases, these bubbles 20 can accumulate, such that the bubbles 20 gradually increase in volume, and float upward in direction A through buoyancy. As shown in Fig. 8, according to exemplary implementations of example embodiments, when these large-volume bubbles 20 float upward in direction A and touch the protruding structures 141 of the piercing components 14, the protruding structures 141 can pierce the large-volume bubbles 20, such that the large-volume bubbles 20 can be dispersed into multiple small-volume bubbles 20. Thus, according to exemplary embodiments of the disclosure, the vapor in the small-volume bubbles 20 can be more easily discharged from the liquid storage space 111, to reduce the obstruction caused by the bubbles 20 to the flow of the cooling fluid L, and thereby reduce the pressure drop and increase the cooling efficiency.

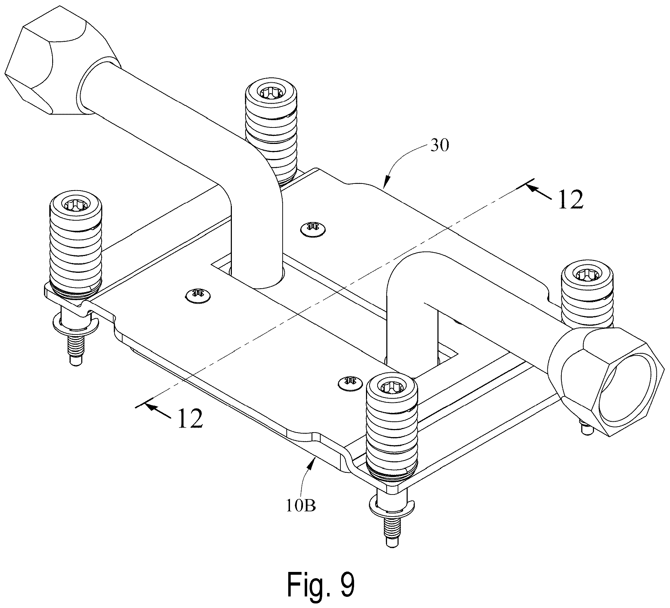

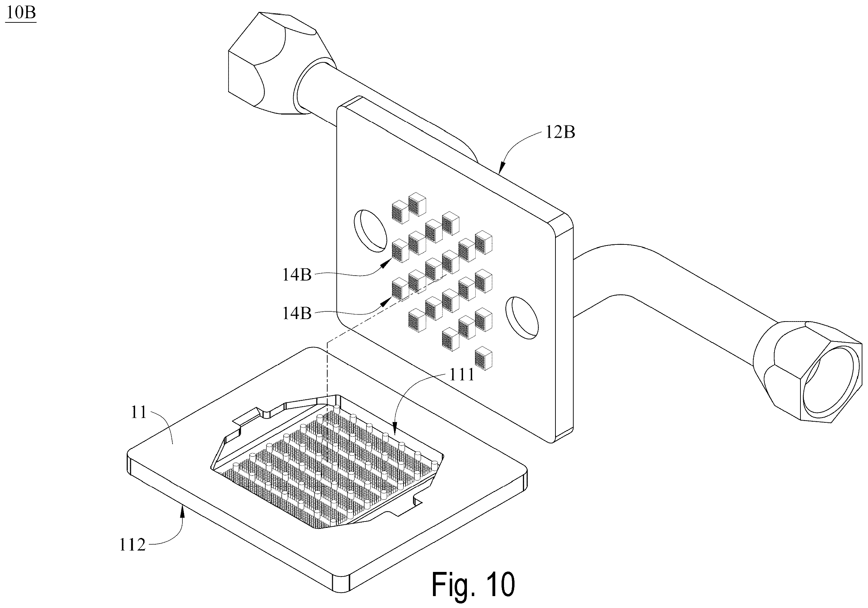

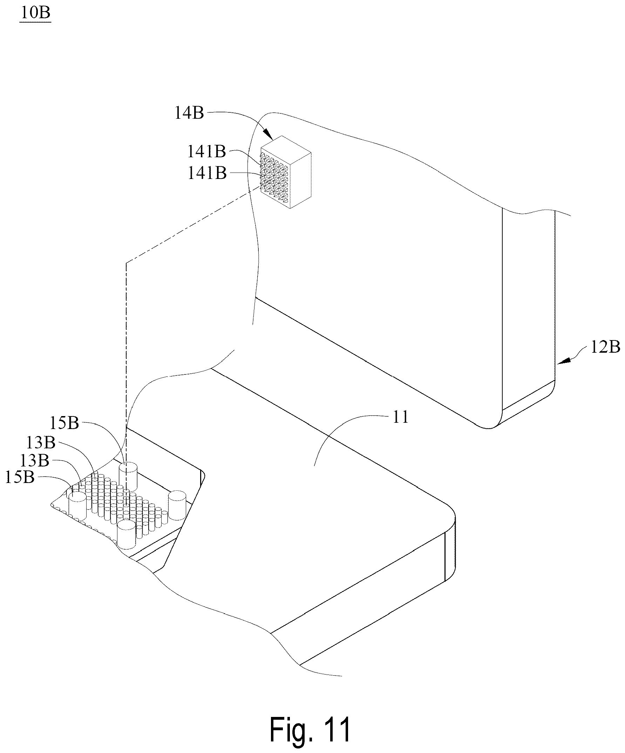

Referring to Figs. 9 - 11, Fig. 9 is a 3D schematic drawing of a liquid cooling device according to a second exemplary embodiment of the present disclosure, Fig. 10 is an exploded schematic drawing of the liquid cooling device in Fig. 9, and Fig. 11 is a partially enlarged exploded schematic drawing of the liquid cooling device in Fig. 9.

According to exemplary implementations of disclosed exemplary embodiments, the liquid cooling device 10B of an example embodiment is similar to the liquid cooling device 10 of an example first embodiment, where in exemplary implementations the differences between a second example embodiment and a first example embodiment are explained, without limitations, below, but similar or identical features are not described for conciseness and not as a limitation. A liquid cooling device 10B according to an exemplary implementation of disclosed embodiment may be fixed to an electronic device by means of an assembly component 30 for example, and can comprise a thermal conduction base 11, a thermal conduction cover 12B, multiple cooling structures 13B and multiple piercing components 14B.

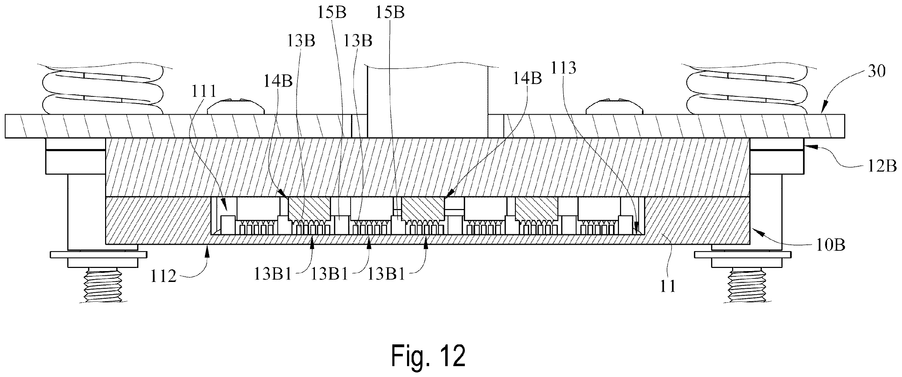

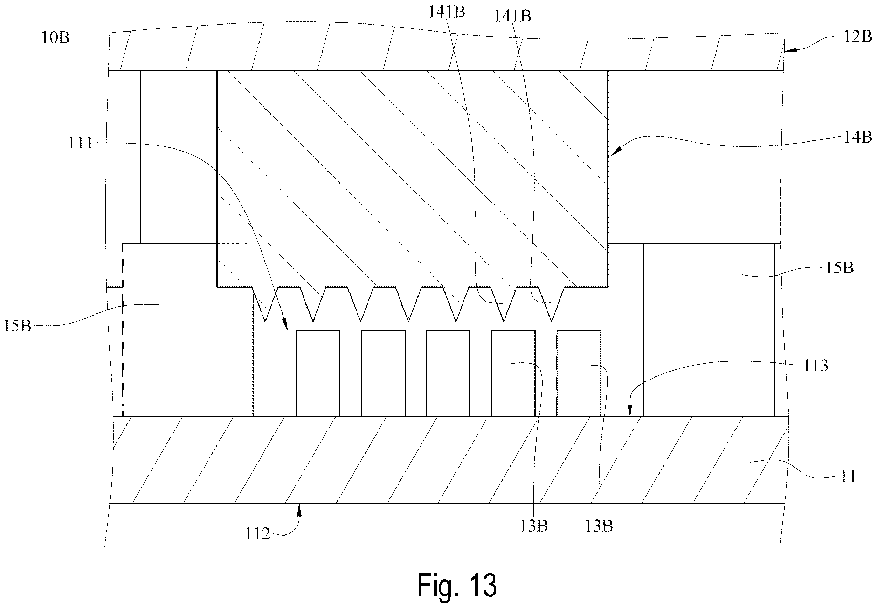

Referring to Figs. 12 and 13, Fig. 12 is a sectional schematic drawing taken along section line 12-12 in the liquid cooling device in Fig. 9, and Fig. 13 is a partially enlarged sectional schematic drawing of the liquid cooling device in Fig. 9.

According to exemplary implementation of example embodiments, the thermal conduction base 11 has a liquid storage space 111, a thermal contact surface 112 and a bottom surface 113. In an exemplary implementation, the thermal contact surface 112 faces away from the liquid storage space 111. The bottom surface 113 can be located in the liquid storage space 111, and faces away from the thermal contact surface 112. The thermal conduction cover 12B can be arranged on the thermal conduction base 11, and can cover the liquid storage space 111.

According to further exemplary implementations of example embodiments, a distance between the center of each cooling structure 13B and the center of another cooling structure 13B adjacent thereto is 0.75 mm for example. In an exemplary implementation, the cooling structures 13B can protrude from the bottom surface 113, and can take the form of round posts for example. In an exemplary implementation, the cooling structures 13B can be divided into multiple groups of cooling structures 13B 1. The piercing components 14B can be copper blocks for example, and can be integrally formed with the thermal conduction cover 12B for example. The piercing components 14B can have multiple protruding structures 141B, and the protruding structures 141B of the piercing components 14B cane take the form of square pyramids for example. The protruding structures 141B are separated from the cooling structures 13B.

According to still further exemplary implementations of example embodiments, the liquid cooling device 10B may further comprise multiple upright posts 15B. The upright posts 15B can take the form of round posts for example. The upright posts 15B can protrude from the bottom surface 113, and can be respectively located in a gap between any adjacent two of the groups of cooling structures 13B1. In an exemplary implementation, the liquid cooling device 10B may not comprise a capillary structure.

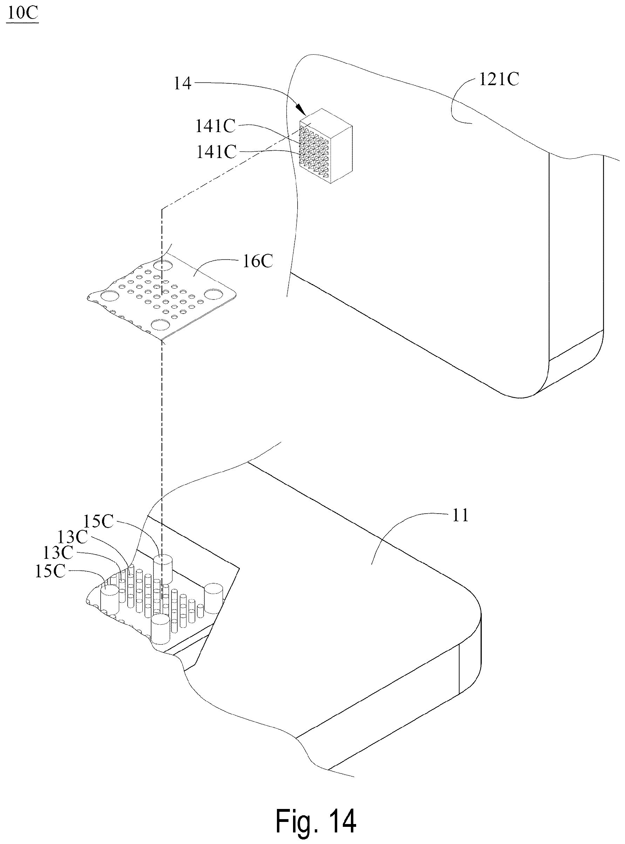

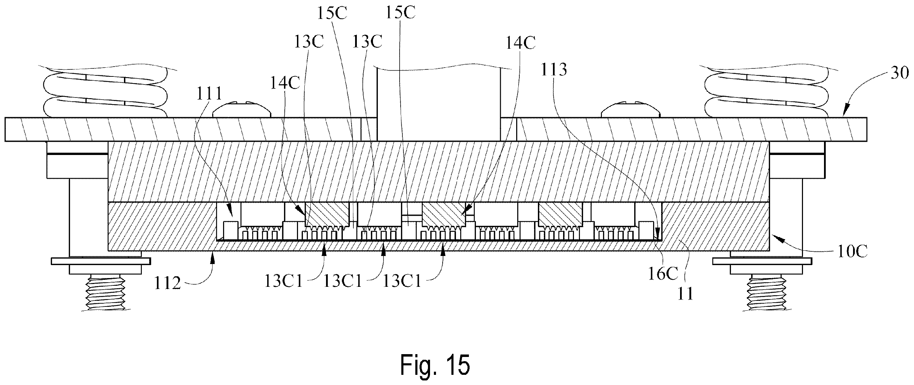

Referring to Figs. 14 - 16, Fig. 14 is a partially enlarged exploded schematic drawing of a liquid cooling device according to a third exemplary embodiment of the present disclosure. Fig. 15 is a sectional schematic drawing of the liquid cooling device in Fig. 14.

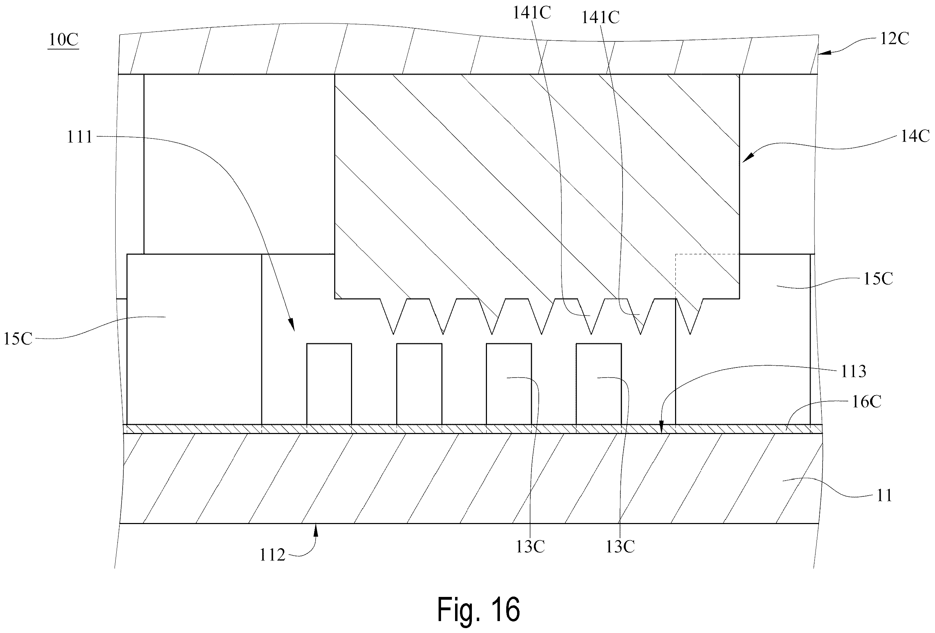

Fig. 16 is a partially enlarged sectional schematic drawing of the liquid cooling device in Fig. 14.

According to exemplary implementations of disclosed exemplary embodiments, the liquid cooling device 10C of an example embodiment is similar to the liquid cooling device 10B of a second embodiment, where in exemplary implementations the differences between a third example embodiment and a first and/or second example embodiment are explained, without limitation, below, but similar or identical features are not described for conciseness and not as a limitation. In an exemplary implementation of disclosed embodiment, the liquid cooling device 10C can be provided with a capillary structure 16C. The capillary structure 16C can be a copper mesh for example, and can be sintered to the bottom surface 113 of the thermal conduction base 11 of the liquid cooling device 10C. In a further exemplary implementation of disclosed embodiment, a distance between the center of each cooling structure 13C and the center of another cooling structure 13C adjacent thereto can be 1 mm for example.

According to an exemplary implementation, in a liquid cooling device in the example embodiment above, after absorbing heat transferred by a heat source, a cooling fluid can boil and produce bubbles, and as the period of operation of the liquid cooling device increases, the bubbles can gradually accumulate and thereby increase in volume, and then can obstruct the flow of cooling fluid and increase a pressure drop, thus reducing the cooling efficiency. At least for this reason, according to exemplary implementations of example embodiments of the disclosure, piercing components are provided in the liquid cooling device, so that when the large-volume bubbles float upward, the piercing components can pierce the large-volume bubbles to disperse them into multiple small-volume bubbles, so that the small-volume bubbles can be discharged from the liquid storage space more easily. In this way, according to exemplary implementations, obstruction to the flow of cooling fluid can be reduced without affecting heat transfer, so the cooling efficiency can, but is not required to, be increased.

The above-presented description and figures are intended by way of example only and are not intended to limit the illustrative embodiments in any way except as set forth in the appended claims. It is particularly noted that various technical aspects of the various elements of the various exemplary embodiments that have been described above can be combined in numerous other ways, all of which are considered to be within the scope of the disclosure.

Accordingly, although exemplary embodiments have been disclosed for illustrative purposes, those skilled in the art will appreciate that various modifications, additions, and substitutions are possible. Therefore, the disclosure is not limited to the above-described embodiments, but may be modified within the scope of appended claims, along with their full scope of equivalents.

The terms and corresponding labels referenced in the disclosure are listed below for convenience. As would be readily appreciated by skilled artisans in the relevant art, while these and other descriptive terms are used throughout this specification to facilitate understanding, it is not intended to limit any components that can be used in combinations or individually to implement various aspects of the embodiments of the present disclosure.
- 10, 10B, 10C:: liquid cooling device
- 11:: thermal conduction base
- 111:: liquid storage space
- 112:: thermal contact surface
- 113:: bottom surface
- 1131:: first surface part
- 1132:: second surface part
- 12, 12B, 12C:: thermal conduction cover
- 121, 121C:: plate body
- 122:: outlet/inlet pipes
- 1221:: exit/entry ports
- 13, 13B, 13C:: cooling structures
- 13A, 13B1, 13C1:: groups of cooling structures
- 13A1:: rows of cooling structures
- 14, 14B, 14C:: piercing components
- 141, 141B, 141C:: protruding structures
- 15, 15B, 15C:: upright posts
- 16, 16C:: capillary structure
- 20:: bubbles
- 30:: assembly component
- A:: direction
- D 1 - D4:: spacings
- H:: heat source
- H1, H2:: heights

Accordingly, although exemplary embodiments have been disclosed for illustrative purposes, those skilled in the art will appreciate that various modifications, additions, and substitutions are possible. Therefore, the disclosure is not limited to the above-described embodiments, but may be modified within the scope of appended claims, along with their full scope of equivalents.

## Claims

1. A liquid cooling device (10, 10B, 10C) comprising:
a thermal conduction base (11) having a liquid storage space (111) and a thermal contact surface (112), the thermal contact surface (112) facing away from the liquid storage space (111);
a thermal conduction cover (12, 12B, 12C) configured on the thermal conduction base (11), the thermal conduction cover (12, 12B, 12C) covering the liquid storage space (111); and
at least one piercing component (14, 14B, 14C) configured in the liquid storage space (111), the at least one piercing component (14, 14B, 14C) comprising at least one protruding structure (141, 141B, 141C) facing toward the thermal contact surface (112).

2. The liquid cooling device (10) as claimed in claim 1, further comprising multiple cooling structures (13, 13B, 13C), the thermal conduction base (11) having a bottom surface (113), the bottom surface (113) being located in the liquid storage space (111) and facing away from the thermal contact surface (112), and the cooling structures (13, 13B, 13C) protruding from the bottom surface (113).

3. The liquid cooling device (10) as claimed in claim 2, wherein the bottom surface (113) comprises a first surface part (1131) and two second surface parts (1132), the two second surface parts (1132) being respectively connected to two opposite sides of the first surface part (1131), the first surface part (1131) being closer to the thermal contact surface (112) than the two second surface parts (1132), and the cooling structures (13, 13B, 13C) protruding from the first surface part (1131).

4. The liquid cooling device (10, 10B, 10C) as claimed in claim 2 or 3, wherein each of the cooling structures (13, 13B, 13C) comprises a square post shape.

5. The liquid cooling device (10, 10B, 10C) as claimed in one of claims 2 to 4, wherein the cooling structures (13, 13B, 13C) are divided into multiple groups, each of the multiple groups of the cooling structures (13A, 13B1, 13C1) comprising multiple rows of the cooling structures (13A1), a spacing (D1) between any adjacent two of the multiple groups of the cooling structures (13A, 13B1, 13C1) being greater than a spacing (D2) between any adjacent two of the rows of the cooling structures (13A1) in the same group of the multiple groups, and the at least one piercing component (14, 14B, 14C) comprising multiple piercing components (14, 14B, 14C) divided into multiple rows, each of the multiple rows of the piercing components (14, 14B, 14C) respectively corresponding to each of the multiple groups of the cooling structures (13A, 13B1, 13C1).

6. The liquid cooling device (10, 10B, 10C) as claimed in claim 5, wherein a spacing (D3) between any adjacent two of each row of the piercing components (14, 14B, 14C) is greater than a spacing (D4) between any adjacent two of each group of the cooling structures (13A, 13B1, 13C1).

7. The liquid cooling device (10, 10B, 10C) as claimed in one of claims 2 to 6, further comprising multiple upright posts (15, 15B, 15C), the multiple upright posts (15, 15B, 15C) protruding from the bottom surface (113), and being respectively located in a gap between any adjacent two of the groups of the cooling structures (13A, 13B1, 13C1).

8. The liquid cooling device (10) as claimed in claim 7, wherein a height (H1, H2) of each of the upright posts (15, 15B, 15C) is higher than a height (H1, H2) of each of the cooling structures (13, 13B, 13C).

9. The liquid cooling device (10, 10B, 10C) as claimed in one of claims 2 to 8, wherein a portion of the protruding structures (141, 141B, 141C) of the at least one piercing component (14, 14B, 14C) overlaps a portion of the cooling structures (13, 13B, 13C).

10. The liquid cooling device (10, 10B, 10C) as claimed in one of claims 1 to 9, wherein the protruding structure (141, 141B, 141C) comprises a truncated cone shape or a cone shape.

11. The liquid cooling device (10, 10B, 10C) as claimed in claim 10, wherein the protruding structure (141, 141B, 141C) comprises a truncated pyramid shape or a pyramid shape.

12. The liquid cooling device (10, 10B, 10C) as claimed in one of claims 1 to 11, wherein the at least one piercing component (14, 14B, 14C) comprises copper.

13. The liquid cooling device (10, 10B, 10C) as claimed in one of claims 1 to 12, wherein the at least one piercing component (14, 14B, 14C) is sintered to the thermal conduction cover (12, 12B, 12C).

14. The liquid cooling device (10, 10B, 10C) as claimed in one of claims 1 to 13, further comprising a capillary structure (16, 16C) sintered to the bottom surface (113) of the thermal conduction base (11).

15. The liquid cooling device (10, 10B, 10C) as claimed in one of claims 1 to14, wherein the thermal conduction cover (12, 12B, 12C) comprise two access ports (1221) in communication with the liquid storage space (111).

16. The liquid cooling device (10, 10B, 10C) as claimed in one of claims 1 to 15, wherein the at least one piercing component (14, 14B, 14C) comprise multiple protruding structures (141, 141B, 141C), each of the multiple protruding structures (141, 141B, 141C) facing toward the thermal contact surface (112)
